# EUROPEAN PATENT APPLICATION

(11) **EP 4 845 334 A1**
(43) Date of publication of application: **25.11.2026**
(21) Application number: 25216583.2
(22) Date of filing: 18.11.2025
(51) Int. Cl.: H10D 30/01, H10D 30/60, H10D 62/17, H10D 64/01, H10D 64/27, H10D 64/66

(54) **TRANSISTOR STRUCTURE HAVING STEPPED SPACER**

(30) Priority: 21.05.2025 US 202519214627
(71) Applicant: GlobalFoundries U.S. Inc., Malta, NY 12020 (US)
(72) Inventor: PRITCHARD, David Charles, New York, 12020 (US); LOISEAU, Alain F., New York, 12020 (US); KLEIMAIER, Domink Martin, New York, 12020 (US); TRANTER, Collin Arthur, New York, 12020 (US); LAZAR, Heather R., New York, 12020 (US); FEUILLETTE, Romain H.A., New York, 12020 (US); JAIN, Navneet K., New York, 12020 (US)
(74) Representative: Grünecker Patent- und Rechtsanwälte PartG mbB

(57) **Abstract**

A semiconductor device includes a stepped gate structure over an insulator layer over a base semiconductor layer. The stepped gate structure includes a gate body having a first top edge, and a gate extension region, adjacent the gate body, having a second top edge. The second top edge is below the first top edge. A pair of source/drain regions within the base semiconductor layer and a stepped spacer structure is over the base semiconductor layer. The stepped spacer structure extends along a side surface of the insulator layer and over the second top edge of the stepped gate structure to reduce parasitic capacitance.

## Description

### BACKGROUND

The present disclosure relates generally to integrated circuits, and more specifically, to transistor spacer structures.

Various factors considered in modem transistor design include, but are not limited to, performance improvement, size scaling, and power consumption. Oftentimes design changes with respect to one of these factors can result in an undesirable trade-off with respect to one or more of the other factors. For example, designs for metal-oxide semiconductor field effect transistors (MOSFETs) have been developed utilizing an insulator layer (e.g., buried oxide (BOX)) of semiconductor-on-insulator processing technology platforms (e.g., a fully depleted semiconductor-on-insulator (FDSOI) processing technology platform) as a gate insulator layer, i.e., buried oxide semiconductor field effect transistors (BOXFETs). Advantages of such a transistor include, for example, FET size scaling and optional back gate biasing (e.g., forward back biasing (FBB) or reverse back biasing (RBB)) to fine tune the threshold voltages (VTs) of the FETs. Such configurations of transistors, however, do not account for parasitic capacitance that may reduce performance.

### SUMMARY

All aspects, examples and features mentioned below can be combined in any technically possible way.

An aspect of the disclosure provides a semiconductor device comprising: a stepped gate structure over an insulator layer over a base semiconductor layer, wherein the stepped gate structure includes: a gate body having a first top edge, and a gate extension region, adjacent the gate body, having a second top edge, wherein the second top edge is below the first top edge; a pair of source/drain regions within the base semiconductor layer; and a stepped spacer structure over the base semiconductor layer, wherein the stepped spacer structure extends along a side surface of the insulator layer and over the second top edge of the stepped gate structure.

An aspect of the disclosure provides a field-effect transistor (FET) device comprising: an insulator layer over a base semiconductor layer, the insulator layer including: a pair of opposing first side surfaces, and a pair of opposing second side surfaces extending between the pair of opposing first side surfaces; a stepped gate structure over the insulator layer, wherein the stepped gate structure includes: a gate body having a first top edge, and a gate extension region, adjacent the gate body, having a second top edge, wherein the second top edge is below the first top edge; a pair of source/drain regions within the base semiconductor layer; a stepped spacer structure over the base semiconductor layer, wherein the stepped spacer structure extends along a length of the pair of opposing first side surfaces of the insulator layer and over the second top edge of the stepped gate structure; and additional gate structures extending over a portion of the second top edge of the gate extension region adjacent to the pair of opposing second side surfaces of the insulator layer.

An aspect of the disclosure provides a method comprising: forming a stepped gate structure over an insulator layer over a base semiconductor layer, wherein the stepped gate structure includes: a gate body having a first top edge, and a gate extension region, adjacent the gate body, having a second top edge, wherein the second top edge is below the first top edge; forming a pair of source/drain regions within the base semiconductor layer; and forming a stepped spacer structure over the base semiconductor layer, wherein the stepped spacer structure extends along a side surface of the insulator layer and over the second top edge of the stepped gate structure.

Two or more aspects described in this disclosure, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The embodiments of this disclosure will be described in detail, with reference to the following figures, wherein like designations denote like elements, and wherein:
FIG. 1 shows a cross-sectional view of the fabrication of a semiconductor device after a number of initial steps, according to embodiments of the disclosure;
FIG. 2 shows a cross-sectional view of the fabrication of a semiconductor device with trench isolation regions, after a number of initial steps, according to embodiments of the disclosure;
FIG. 3 shows a cross-sectional view of forming a stepped spacer structure, according to embodiments of the disclosure;
FIG. 4 shows a cross-sectional view of forming a stepped spacer structure, according to embodiments of the disclosure;
FIG. 5 shows a cross-sectional view of forming a stepped gate structure, a back terminal, and raised portions of a pair of source/drain regions, according to embodiments of the disclosure;
FIG. 6 shows a top view of a semiconductor device with a stepped gate structure and a stepped spacer structure, according to embodiments of the disclosure;
FIG. 7 shows a cross-sectional view of the semiconductor device of FIG. 6 along view line A-A, according to embodiments of the disclosure;
FIG. 8 shows a top view of a semiconductor device with a stepped gate structure and additional gate structures, according to other embodiments of the disclosure; and
FIG. 9 shows a cross-sectional view of the semiconductor device of FIG. 8 along view line B-B, according to other embodiments of the disclosure.

It is noted that the drawings of the disclosure are not necessarily to scale. The drawings are intended to depict only typical aspects of the disclosure and therefore should not be considered as limiting the scope of the disclosure. In the drawings like numbering represents like elements between the drawings.

### DETAILED DESCRIPTION

In the following description, reference is made to the accompanying drawings that form a part thereof, and in which is shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (A) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

Embodiments of the disclosure include a semiconductor device (herein referred to as device or a field-effect transistor (FET) device) with a stepped gate structure, a pair of source/drain regions, a stepped spacer structure, and a related method. The stepped gate structure may be over an insulator layer over a base semiconductor layer. The stepped gate structure may include a gate body having a first top edge and a gate extension region, adjacent the gate body, having a second top edge. The second top edge is below the first top edge. The pair of source/drain regions are within the base semiconductor layer and the stepped spacer structure may be over the base semiconductor layer and extend along a side surface of the insulator layer and over the second top edge of the stepped gate structure.

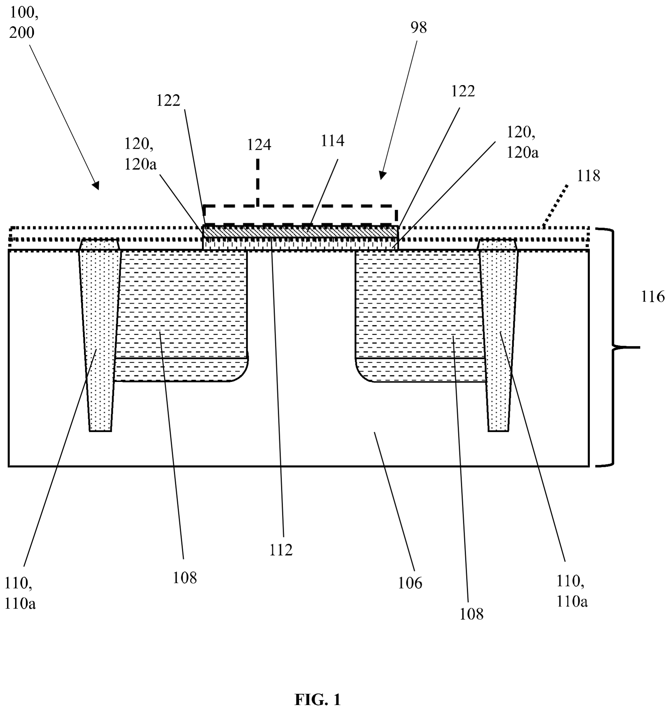

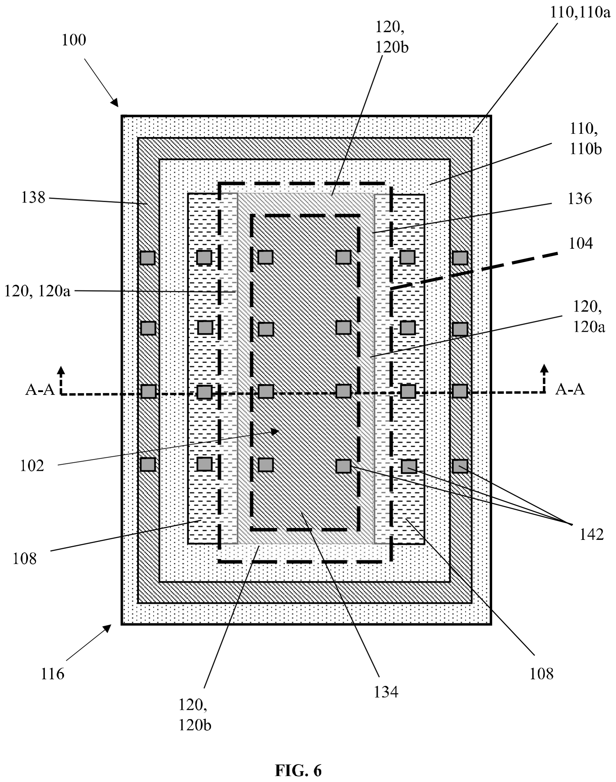

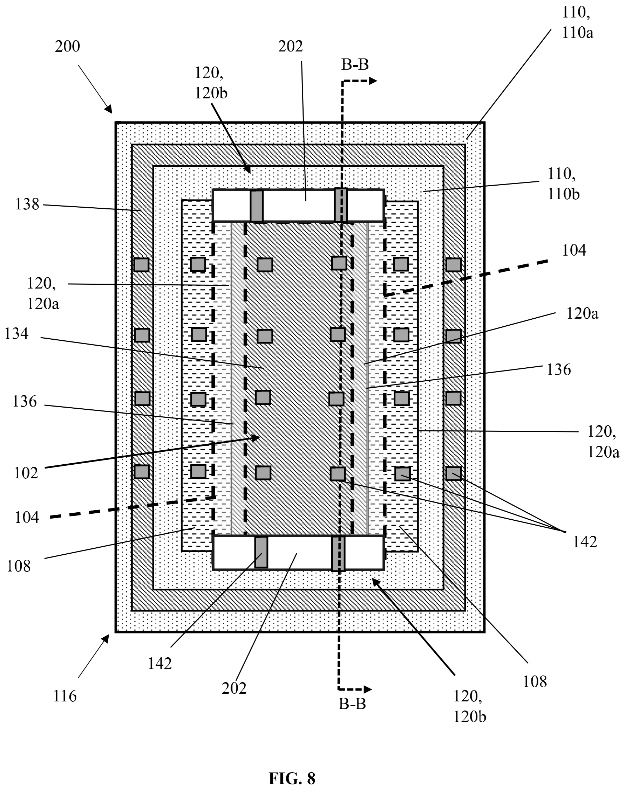

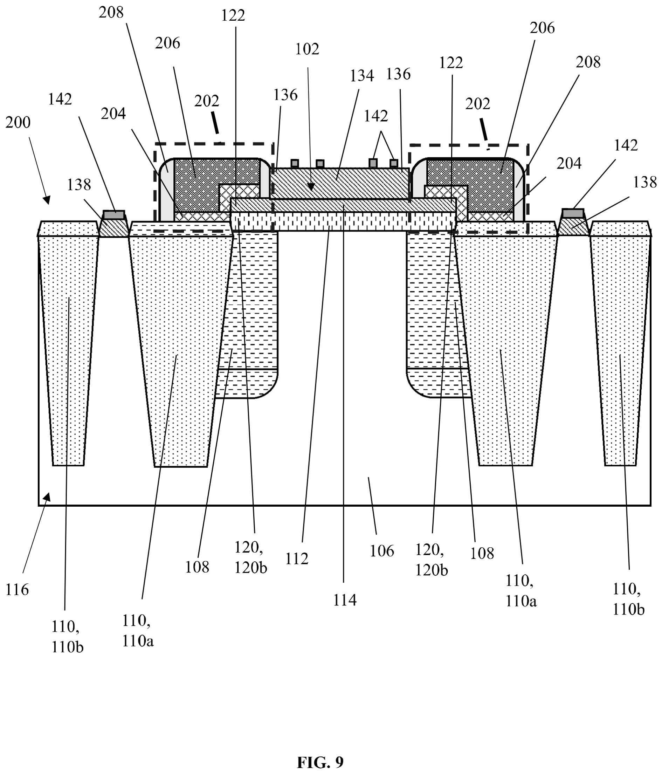

FIGS. 1-5 show cross-sectional views of a method of forming device(s) 100 (FIGS. 6-7), 200 (FIGS. 8-9), according to embodiments of the disclosure. As will be described and as shown in FIGS. 6-9, the method allows fabrication of device(s) 100 (FIGS. 6-7), 200 (FIGS. 8-9) having a stepped gate structure 102 and a stepped spacer structure 104 (not shown in FIG. 9).

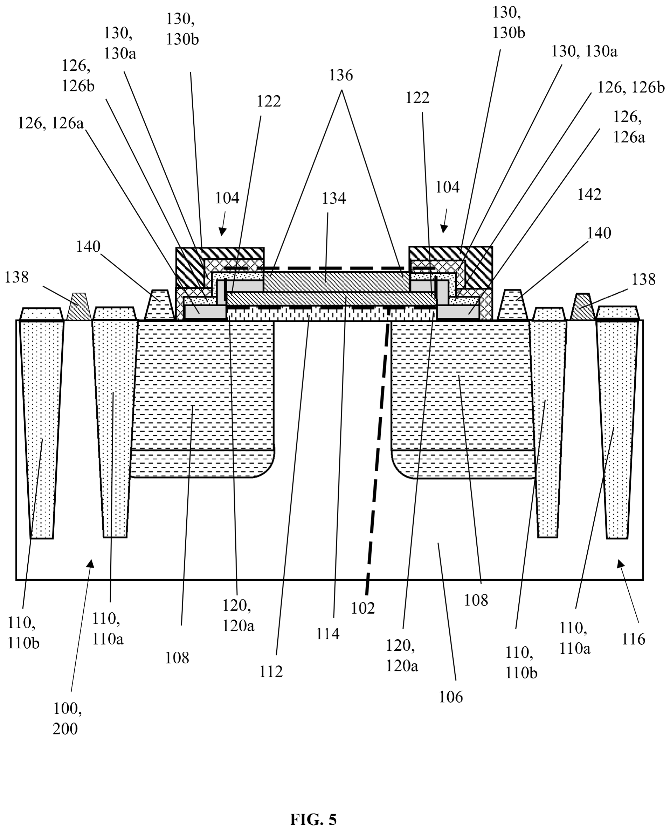

FIG. 1 shows a cross-sectional view of a preliminary structure 98 for the fabrication of device(s) 100 (FIGS. 6-7), 200 (FIGS. 8-9), after a number of initial steps, including forming within a base semiconductor layer 106, a pair of source/drain regions 108, and trench isolation region(s) 110. Further, an insulator layer 112 may be formed over base semiconductor layer 106, and a gate extension region 114 (of eventually formed stepped gate structure 102 (FIGS. 5-9)) may be formed over insulator layer 112.

As shown in FIG. 1, preliminary structure 98 may include a semiconductor-on-insulator (SOI) substrate 116. For the purposes of this description, SOI substrate 116, as shown in FIG. 1, is illustrated as a fully depleted semiconductor-on-insulator (FDSOI) substrate. An FDSOI substrate is a planar substrate that uses an ultra-thin, insulator layer 112 (e.g., buried insulator layer or buried oxide (BOX)) positioned on top of a base semiconductor layer 106, and a semiconductor-on-insulator (SOI) layer 118 (shown in a dashed box) positioned over insulator layer 112. Base semiconductor layer 106 may be formed using any known or later developed semiconductor fabrication process(es). In some embodiments, base semiconductor layer 106 may be formed by deposition (e.g., epitaxial growth) and subsequent planarization. Any deposition described herein may include any now known or later developed techniques appropriate for the material to be deposited, including but are not limited to: chemical vapor deposition (CVD), low-pressure CVD (LPCVD), plasma-enhanced CVD (PECVD), semi-atmosphere CVD (SACVD) and high density plasma CVD (HDPCVD), rapid thermal CVD (RTCVD), ultra-high vacuum CVD (UHVCVD), limited reaction processing CVD (LRPCVD), metalorganic CVD (MOCVD), sputtering deposition, ion beam deposition, electron beam deposition, laser assisted deposition, thermal oxidation, thermal nitridation, spin-on methods, physical vapor deposition (PVD), atomic layer deposition (ALD), chemical oxidation, molecular beam epitaxy (MBE), plating, evaporation. Any planarization described herein may include any now known or later developed techniques appropriate for making a surface planar (that is, flat and/or smooth), for example, chemical-mechanical-polishing (CMP). Base semiconductor layer 106 may include but is not limited to: silicon, germanium, silicon germanium, silicon carbide, and those consisting essentially of one or more III-V compound semiconductors having a composition defined by the formula A1X1GaX2InX3AsY1PY2NY3SbY4, where X1, X2, X3, Y1, Y2, Y3, and Y4 represent relative proportions, each greater than or equal to zero and X1+X2+X3+Y1+Y2+Y3+Y4=1 (1 being the total relative mole quantity). Other suitable substrates include II-VI compound semiconductors having a composition ZnA1CdA2SeB1TeB2, where A1, A2, B1, and B2 are relative proportions each greater than or equal to zero and A1+A2+B1+B2=1 (1 being a total mole quantity). The precise thickness of base semiconductor layer 106 may vary widely based on the intended application. Various portions of base semiconductor layer 106 may be doped with p-type and/or n-type dopants, by any now known or later developed fashion, e.g., in-situ doping during formation, or ion implanting, to provide a desired conductivity type.

As shown in FIG. 1, SOI substrate 116 may include an insulator layer 112 on base semiconductor layer 106, and an SOI layer 118 that will be formed into gate extension region 114. Insulator layer 112 and SOI layer 118 may be formed using any known or later developed semiconductor fabrication process(es) e.g., deposition and patterning. In some embodiments, insulator layer 112 may be deposited over base semiconductor layer 106. SOI layer 118 may then be deposited over insulator layer 112, and a pattemed mask 124 (shown by dashed box) may be formed over SOI layer 118. Any patterned mask described herein may be any currently known or later developed material for masking, examples including nitride and photoresist. After patterned mask 124 is formed, one or more etching processes may be used, where there are openings in the patterned mask, to remove portions of the underlying material to form the shape of insulator layer 112 and gate extension region 114 (as shown in FIG. 1-5, 7, and 9). Any masks described herein may be removed using any known removal process appropriate for the mask material, e.g., a wet etch for a hard nitride mask or an ashing process (oxygen dry strip process) for a soft resist-based mask. As these processes are well known, no further details are provided so the reader can focus on the salient aspects of the disclosure. It will be recognized that in other embodiments, insulator layer 112 and gate extension region 114 may be sequentially deposited and patterned separately. Insulator layer 112 may be composed of one or more oxide compounds, and/or any other currently known or later-developed electrically insulating substances, such as but not limited to silicon dioxide, i.e., forming a buried oxide (BOX) layer. In some embodiments, insulator layer 112 may include side surface(s) 120. As shown in FIG. 1, side surface(s) 120 may be comprised of a pair of opposing first side surfaces 120a and, as shown in FIG. 6, a pair of opposing second side surfaces 120b extending between pair of opposing first side surfaces 120a. As noted, gate extension region 114 (of eventually formed stepped gate structure 102 (FIGS. 5-9)) may be formed from SOI layer 118, on insulator layer 112. Gate extension 114 may be formed of any known or later developed conductive material. For example, gate extension region 114 may include polycrystalline silicon (polysilicon). Further, the polysilicon material may be doped with p-type and/or n-type dopants, by any now known or later developed fashion (e.g., in-situ doping during formation) depending on whether device(s) 100 (FIGS. 6-7), 200 (FIGS. 8-9) are an NFET or PFET device. Gate extension region 114 may include a second top edge 122, e.g., along the border of a side surface of gate extension region 114 and a top surface of gate extension region 114. In some embodiments, insulator layer 112 and gate extension region 114 may extend over a portion of an (eventually formed) pair of source/drain regions 108. The precise thickness of insulator layer 112 and gate extension region 114 may vary widely with the intended application. In some embodiments, the combination of insulator layer 112, gate extension region 114 (of eventually formed stepped gate structure 102 (FIGS. 5-9)) e.g., a doped polysilicon, and to be formed one or more doped polysilicon layers on gate extension region 114, as discussed further herein, can be part of a gate-first polysilicon gate stack. Additionally, portions of SOI layer 118 may not be doped, thus making SOI layer 118 "fully depleted."

As shown in FIG. 1, a pair of source/drain regions 108 may be formed within base semiconductor layer 106. Pair of source/drain regions 108 may be formed using any known or later developed semiconductor doping process(es). In some embodiments, portions of base semiconductor layer 106 may be doped to form pair of source/drain regions 108, e.g., one portion of base semiconductor layer 106 may be doped to form a source region and another portion doped to form a drain region. The doping processes may include, but are not limited to, ion implantation or in-situ doping of semiconductor material. Further, any appropriate mask for doping may be used. As understood in the field, pair of source/drain regions 108 may be doped, electrically active regions that define opposite terminals for current flow. When device(s) 100 (FIGS. 6-7), 200 (FIGS. 8-9) is electrically biased, components thereof may create an electric field to influence their conductivity, thus enabling or preventing flow between pair of source/drain regions 108. Pair of source/drain regions 108 may be doped with a dopant having a selected polarity for a respective transistor. For example, an n-type transistor may include n-type dopants such as but not limited to phosphorus, arsenic, and antimony. Further, a p-type transistor may include p-type dopants such as but not limited to boron, indium, and gallium. For example, in some embodiments, device(s) 100 (FIGS. 6-7), 200 (FIGS. 8-9) may be an N-type FET device (e.g., a buried oxide semiconductor field effect transistors (BOXFET)). In this case, pair of source/drain regions 108 can be doped to have N-type conductivity at a relatively high conductivity level. In other embodiments, device(s) 100 (FIGS. 6-7), 200 (FIGS. 8-9), can be a P-type FET device. In this case, pair of source/drain regions 108 can be doped to have P-type conductivity at a relatively high conductivity level.

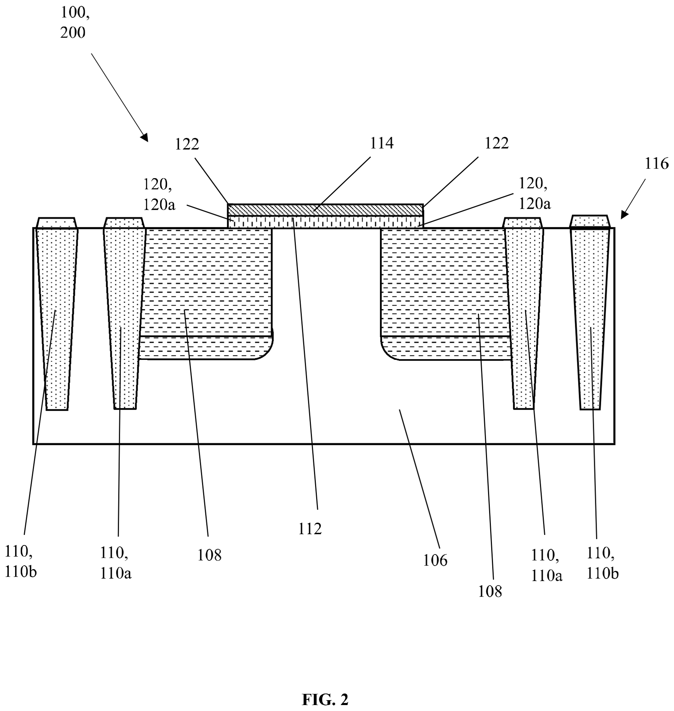

FIG. 1 also shows that various components of device(s) 100 (FIGS. 6-7), 200 (FIGS. 8-9) may be electrically isolated from each other by trench isolation region(s) 110. Trench isolation region(s) 110 may include a trench etched into base semiconductor layer 106 and filled with an insulating material, such as oxide, to isolate one region of SOI substrate 116 from an adjacent region. One or more transistors and/or passive devices (e.g., polycrystalline resistor, inductors, etc.) may be disposed within an area isolated by trench isolation region(s) 110. Trench isolation region(s) 110 may be formed of any currently-known or later developed substance for providing electrical insulation, and as examples may include: silicon nitride, silicon dioxide, fluorinated silicon glass (oxide)(FSG), hydrogenated silicon oxycarbide, boro-phospho-silicate glass (BPSG), silsesquioxanes, carbon doped oxides (i.e., organosilicates) that include atoms of silicon, carbon, oxygen, and/or hydrogen, thermosetting polyarylene ethers, a spin-on silicon-carbon containing polymer material, near frictionless carbon (NFC), or layers thereof. Trench isolation region(s) 110 may be provided as a shallow trench isolation (STI) or a deep trench isolation (DTI). As shown in FIG. 1, trench isolation region(s) 110 may include a first trench isolation region 110a and, as shown in FIG. 2, a second trench isolation region 110b may be optionally laterally adjacent to first trench isolation region 110a. First trench isolation region 110a may be laterally adjacent to and/or surrounding gate extension region 114 (of eventually formed stepped gate structure 102 (FIGS. 5-9)).

FIG. 2 shows a cross-sectional view of forming trench isolation region(s) 110. As noted, in some embodiments, trench isolation region(s) 110 may include a first trench isolation region 110a and a second trench isolation region 110b, within base semiconductor layer 106. As noted, first trench isolation region 110a may surround gate extension region 114 (of eventually formed stepped gate structure 102 (FIGS. 5-9)). Further, second trench isolation region 110b may surround first trench isolation region 110a. As previously described, second trench isolation region 110b may be formed at the same time as first trench isolation region 110a and may be the same materials as first trench isolation region 110a or may be different.

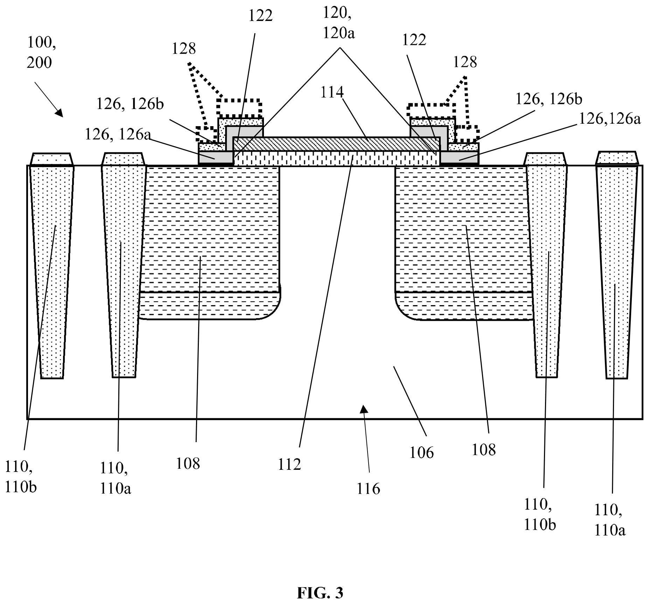

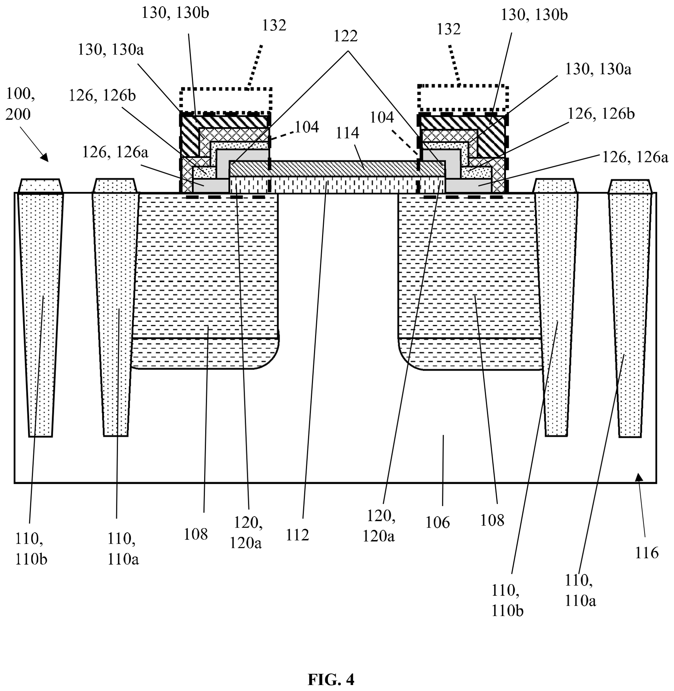

FIG. 3 shows a cross-sectional view of forming a first spacer layer 126 (of eventually formed stepped spacer structure 104 (FIGS. 4-8)), according to embodiments of the disclosure. First spacer layer 126 may be formed using any known or later developed semiconductor fabrication process(es) and may be formed of any currently-known or later developed substance for providing electrical insulation. In some embodiments, first spacer layer 126 may be formed by depositing material over the structures shown in FIGS. 1 or 2. A patterned first spacer layer mask 128 (shown in dashed lines) may then be formed over first spacer layer 126. After patterned first spacer layer mask 128 is formed, etching process(es) may be used, where there are openings in patterned first spacer layer mask 128 (dashed box), to form the shape of first spacer layer 126 (as shown in FIGS. 3-5 and 7). Patterned first spacer layer mask 128 may then be removed using any known removal process appropriate for the mask material. In some embodiments, first spacer layer 126 may be a silicon-based insulator material and examples may include, but are not limited to: silicon nitride, silicon-oxynitride, or silicon-boron-carbonitride. As shown in FIG. 3, first spacer layer 126 may include one or more sub-layers 126a, 126b. Further, sub-layers 126a, 126b may each be composed of the same material or may include different materials. For example, as shown in FIG.3, first spacer layer 126 may include a first sub-layer 126a and a second sub-layer 126b. In some embodiments, first sub-layer 126a, of first spacer layer 126, may include silicon-boron-carbonitride and second sub-layer 126b, of first spacer layer 126, may include silicon nitride. As shown in FIG. 3, first spacer layer 126 may be a stepped structure adjacent to and over second top edge 122 of gate extension region 114 (of eventually formed stepped gate structure 102 (FIGS. 5-9)), extending along side surface(s) 120 of insulator layer 112, and over base semiconductor layer 106.

FIG. 4 shows a cross-sectional view of forming a second spacer layer 130, according to embodiments of the disclosure. Second spacer layer 130 may be formed over first spacer layer 126 and may be formed using any known or later developed semiconductor fabrication process(es). In some embodiments, second spacer layer 130 may be formed by depositing material over the structures shown in FIG. 3. A patterned second spacer layer mask 132 (shown in dashed lines) may then be formed over second spacer layer 130. After patterned second spacer layer mask 132 is formed, etching process(es) may be used, where there are openings in patterned second spacer layer mask 132, to form the shape of second spacer layer 130 (as shown in FIGS. 4, 5, and 7). Patterned second spacer layer mask 132 may then be removed using any known removal process appropriate for the mask material. Further, second spacer layer 130 may be formed of any currently-known or later developed substance for providing electrical insulation. In some embodiments, second spacer layer 130 may be an oxide-based material and, as examples, may include, but is not limited to: ultra-thin dielectric oxide (UDOX) or silicon dioxide. As shown in FIG. 4, second spacer layer 130 may include one or more sub-layers 130a, 130b. Further, sub-layers 130a, 130b may each be composed of the same material or may include different materials. For example, as shown in FIG. 4, second spacer layer 130 may include a first sub-layer 130a and a second sub-layer 130b. In some embodiments, first sub-layer 130a of second spacer layer 130, may include an oxide, and second sub-layer 130b of second spacer layer 130 may include silicon dioxide. The combination of first spacer layer 126 and second spacer layer 130 may form stepped spacer structure 104 (shown in FIG. 4 in dashed boxes).

FIG. 5 shows a cross-sectional view of a step in forming device(s) 100 (FIGS. 6-7), 200 (FIGS. 8-9). In some embodiments, forming device(s) 100 (FIGS. 6-7), 200 (FIGS. 8-9), may include forming a gate body 134 having a first top edge 136 over gate extension region 114, and forming a back terminal 138 for the gate, and raised portions 140 of pair of source/drain regions 108. Gate body 134 may be formed on gate extension region 114 and include a first top edge 136, e.g., along the border of a side surface of gate body 134 and a top surface of gate body 134. In some embodiments first top edge 136 is above second top edge 122 of gate extension region 114. Gate body 134 may be formed using any known or later developed semiconductor fabrication process(es). In some embodiments, gate body 134 may be epitaxially grown from gate extension region 134. Further, gate body 134, raised portions 140 of pair of source/drain regions 108, and back terminal 138 may be epitaxially grown at the same time. Gate body 134 may include the same material as gate extension region 114 (e.g., doped polysilicon). The combination of gate extension region 114 and gate body 134 may form stepped gate structure 102 (shown in FIG. 5 in dashed box). Stepped gate structure 102 may be part of a gate-first polysilicon gate stack, which includes, for example: insulator layer 112; stepped gate structure 102 (e.g., a doped polysilicon) on insulator layer 112; and eventually a metal silicide layer on the one or more doped polysilicon layers. Any metal silicide layer discussed herein may be formed of cobalt silicide, nickel silicide, tungsten silicide, titanium silicide, or any other suitable metal silicide material. Alternatively, stepped gate structure 102 (FIGS. 5-9) can be part of any other suitable type of gate stack (e.g., a replacement metal gate (RMG) structure). Various different gate stacks are known in the art and, thus, the details thereof have been omitted from this specification in order to allow the reader to focus on the salient aspects of the disclosed embodiments. As shown in FIG. 5, gate body 134 may be laterally smaller in size such that the combination of gate body 134 and gate extension region 114 creates a stepped structure upon which stepped spacers are located.

As shown in FIG. 5, in forming device(s) 100 (FIGS. 6-7), 200 (FIGS. 8-9), raised portions 140 of pair of source/drain regions 108 may be formed over base semiconductor layer 106. Raised portions 140 of pair of source/drain regions 108 may be formed using any known or later developed semiconductor fabrication process(es). In some embodiments, raised portions 140 of pair of source/drain regions 108 may be formed using epitaxially grown monocrystalline (e.g., epitaxially grown silicon layers). In some embodiments, gate body 134, raised portions 140 of pair of source/drain regions 108, and back terminal 138 may be epitaxially grown at the same time. Raised portions 140 may be doped by any known or later developed doping process(es) including, for example, in-situ doping of semiconductor material during epitaxial growth so as to have the same conductivity type as pair of source/drain regions 108 (e.g., N-type conductivity) but at a higher conductivity level. In some embodiments, raised portions 140 may be positioned over pair of source/drain regions 108, such that they are laterally between first trench isolation region 110a and stepped spacer structure 104.

Continuing with FIG. 5, methods of making device(s) 100 (FIGS. 6-7), 200 (FIGS. 8-9) may include forming back terminal 138. Back terminal 138 may be formed using any known or later developed semiconductor fabrication process(es). In some examples, as noted, back terminal 138 may be formed by epitaxial growth. More particularly, back terminal 138 may be formed using epitaxially grown monocrystalline (e.g., epitaxially grown silicon layers). Back terminal 138 may be laterally separated from stepped gate structure 102 by first trench isolation region 110a, surrounding stepped gate structure 102. In some embodiments, back terminal 138 may be surrounded by second trench isolation region 110b. Further, back terminal 138 may be "floating" in that back terminal 138 may not be electrically coupled to a predetermined voltage bias, i.e., its voltage level at a given time during operation depends at least partially on the voltage level of other materials coupled thereto. Further, stepped gate structure 102 may be connected to a primary gate voltage and back terminal 138 may be connected to a secondary gate voltage and to base semiconductor layer 106. Depending on the secondary gate voltage, back terminal 138 may be connected to ground or act as a functional back gate. For example, back terminal 138 may not be biased and act as ground contact. In other embodiments, back terminal 138 may be biased to allow forward back biasing (FBB) or reverse back biasing (RBB) to fine-tune the threshold voltages (VTs) of stepped gate structure 102. Given the above-described structure stepped gate structure 102 and back terminal 138 are independently biasable. That is, they can be biased with the same or different bias voltages. A metal silicide layer (not shown) may also be formed over back terminal 138.

FIG. 6 shows a top view of a device 100 (FIGS. 6-7) e.g., a FET device, including trench isolation region(s) 110, stepped spacer structure 104 (shown in dashed box), pair of source/drain regions 108, stepped gate structure 102 (shown in dashed box), contacts 142, and back terminal 138. A step in forming device(s) 100 (FIGS. 6-7), 200 (FIGS. 8-9), may include forming contacts 142, for accessing various components (e.g., to bias the pair of source/drain regions 108 and/or to allow the pair of source/drain regions 108 to be electrically connected to other on-chip components, such as front end of the line (FEOL), middle of the line (MOL), or back end of line (BEOL) components). Contacts 142 may be formed using any known or later developed semiconductor fabrication process(es) (e.g., deposition). In one non-limiting example, contacts 142 may be formed by depositing an interlayer dielectric layer, patterning a mask (not shown), etching contact openings to the respective structures, and forming a conductor in the openings. The conductor may include a refractory metal liner, and a contact metal. The refractory metal liner (not shown for ease of illustration) may include, for example, titanium nitride. Contacts 142 may be any now known or later developed contact metal such as but not limited to tungsten. Contacts 142 may be formed on portions of stepped gate structure 102, back terminal 138, and/or pair of source/drain regions 108 (e.g., on a metal silicide layer, not shown for ease of illustration). For example, contacts 142 may be formed on back terminal 138, raised portions 140 of pair of source/drain regions 108, and gate body 134 of stepped gate structure 102.

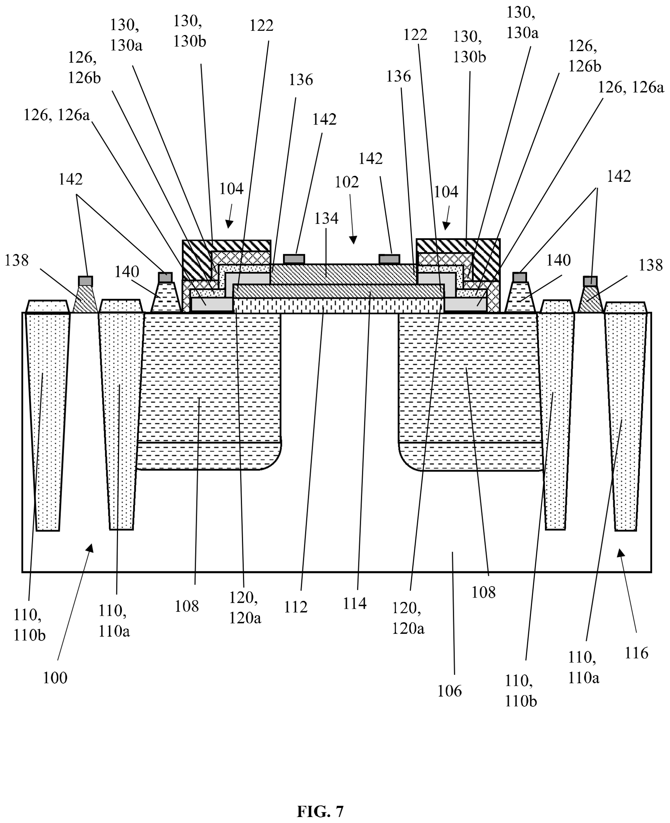

FIG. 7 shows a cross-sectional view of device 100 (FIGS. 6-7) of FIG. 6, along view line A-A. Device 100 (FIGS. 6-7) may include trench isolation region(s) 110, stepped spacer structure 104, pair of source/drain regions 108, stepped gate structure 102, contacts 142, and back terminal 138, and insulator layer 112. As shown in FIG. 7, first spacer layer 126 and second spacer layer 130 may vary in width from layer to layer and may extend above and over stepped gate structure 102.

FIG. 8 shows a top view of device 200 (FIGS. 8-9 e.g., FET device) including additional gate structures 202 (shown in dashed boxes). Device 200 (FIGS. 8-9) may include insulator layer 112 over base semiconductor layer 106, insulator layer 112 including pair of opposing first side surfaces 120a, and pair of opposing second side surfaces 120b extending between pair of opposing first side surfaces 120a. Device 200 (FIGS. 8-9) may further include stepped gate structure 102 over insulator layer 112 over base semiconductor layer 106. As noted, stepped gate structure 102 may include gate body 134 having first top edge 136, and gate extension region 114, adjacent gate body 134, having second top edge 122. Second top edge 122 may be below first top edge 136. As previously noted, device 200 (FIGS. 8-9) may include stepped spacer structure 104 (shown in FIG. 8) over base semiconductor layer 106. Stepped spacer structure 104 may extend along a length of pair of opposing first side surfaces 120a but not pair of opposing second side surfaces 120b. Further, stepped spacer structure 104 may be over the second top edge 122 of stepped gate structure 102. Embodiments may further comprise additional gate structure 202 extending over a portion of second top edge 122 of gate extension region 114 adjacent to pair of opposing second side surfaces 120b of insulator layer 112. In some embodiments, a portion of additional gate structures 202, may be formed over first trench isolation region 110a and may extend over a portion of second top edge 122 of gate extension region 114. Additional gate structures 202 may be formed using any known or later developed semiconductor fabrication process(es), as described herein.

FIG. 9 shows a cross-sectional view of device 200 along view line B-B of FIG. 8 and including additional gate structures 202. Additional gate structures 202 may include any now known or later developed gate material such as but not limited to polysilicon or a metal gate stack. In some embodiments, additional gate structures 202 may be a gate-first polysilicon gate stacks, which includes, for example: a gate insulator layer 204; a polysilicon layer 206 on gate insulator layer 204; and a metal silicide layer (not shown) on polysilicon layer 206, and a set of spacers 208. Alternatively, the additional gate structures 202 can be part of any other suitable type of gate stack (e.g., a replacement metal gate (RMG) structure). Various different gate stacks and methods of forming(e.g., deposition) are known in the art and, thus, the details thereof have been omitted from this specification in order to allow the reader to focus on the salient aspects of the disclosed embodiments As shown in FIG. 9, additional gate structures 202 can further include a set of spacers 208 horizontally adjacent to the gate stack, to electrically isolate additional gates structures 202 from other devices. In some embodiments, one spacer of the set of spacers 208 may be on first trench isolation region 110a and the other spacer of the set of spacers 208 may be on the top surface of gate extension region 114. Further, one spacer of the set of spacers 208 may be adjacent gate body 134 of stepped gate structure 102. In some embodiments, additional gate structures 202 may also be biased during operation to compensate for parasitic capacitance. In other embodiments, additional gate structures 202 may be electrically inactive gate structure "dummy gate" acting as an electric field insulator.

The present disclosure provides various technical and commercial advantages, examples of which are discussed herein. Embodiments of device(s) 100 (FIGS. 6-7), 200 (FIGS. 8-9) utilize insulator layer 112 as a gate insulator, allowing device(s) 100 (FIGS. 6-7), 200 (FIGS. 8-9) to occupy a reduced area as compared to conventional FETs. Additionally, stepped spacer structure 104 and/or additional gate structures 202 protect the edges of stepped gate structure 102, causing reduced parasitic capacitance.

The method and structure as described above are used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a center processor.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about," "approximately," and "substantially," are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, a semiconductor device includes a stepped gate structure over an insulator layer over a base semiconductor layer. The stepped gate structure includes a gate body having a first top edge, and a gate extension region, adjacent the gate body, having a second top edge. The second top edge is below the first top edge. A pair of source/drain regions within the base semiconductor layer and a stepped spacer structure is over the base semiconductor layer. The stepped spacer structure extends along a side surface of the insulator layer and over the second top edge of the stepped gate structure to reduce parasitic capacitance.

The following embodiments are explicitly disclosed.

### Embodiment 1:

A semiconductor device comprising:
a stepped gate structure over an insulator layer over a base semiconductor layer, wherein the stepped gate structure includes:
   a gate body having a first top edge, and
   a gate extension region, adjacent the gate body, having a second top edge, wherein the second top edge is below the first top edge;
a pair of source/drain regions within the base semiconductor layer; and
a stepped spacer structure over the base semiconductor layer,
wherein the stepped spacer structure extends over the second top edge of the stepped gate structure.

In some illustrative examples herein, the stepped spacer structure may extend along a side surface of the insulator layer and over the second top edge of the stepped gate structure.

### Embodiment 2:

The semiconductor device of embodiment 1, wherein the stepped spacer structure includes:
a first spacer layer, including a first material, adjacent to and over the second top edge of the stepped gate structure, the first spacer layer extending along the side surface of the insulator layer and over the base semiconductor layer; and
a second spacer layer, including a second material, over the first spacer layer, wherein the first material and the second material are different.

### Embodiment 3:

The semiconductor device of embodiment 2, wherein the first material is silicon-based.

### Embodiment 4:

The semiconductor device of one of embodiments 1 to 3, wherein the gate extension region is over a portion of at least one source/drain region of the pair of source/drain regions.

### Embodiment 5:

The semiconductor device of one of embodiments 1 to 4, further comprising a trench isolation region in the base semiconductor layer.

### Embodiment 6:

The semiconductor device of one of embodiments 1 to 5, wherein the insulator layer includes:
a pair of opposing first side surfaces; and
a pair of opposing second side surfaces between the pair of opposing first side surfaces, wherein the stepped spacer structure extends along a length of the pair of opposing first side surfaces but not the pair of opposing second side surfaces.

### Embodiment 7:

The semiconductor device of embodiment 6, further comprising additional gate structures extending over a portion of the second top edge of the gate extension region adjacent to the pair of opposing second side surfaces of the insulator layer.

### Embodiment 8:

The semiconductor device of one of embodiments 1 to 7, wherein the insulator layer comprises:
a pair of opposing first side surfaces, and
a pair of opposing second side surfaces extending between the pair of opposing first side surfaces,
wherein the stepped spacer structure extends along a length of the pair of opposing first side surfaces of the insulator layer and over the second top edge of the stepped gate structure, and
wherein the stepped gate structure further comprises additional gate structures extending over a portion of the second top edge of the gate extension region adjacent to the pair of opposing second side surfaces of the insulator layer.

### Embodiment 9:

A field-effect transistor (FET) device comprising:
an insulator layer over a base semiconductor layer, the insulator layer including:
   a pair of opposing first side surfaces, and
   a pair of opposing second side surfaces extending between the pair of opposing first side surfaces;
a stepped gate structure over the insulator layer, wherein the stepped gate structure includes:
   a gate body having a first top edge, and
   a gate extension region, adjacent the gate body, having a second top edge, wherein the second top edge is below the first top edge;
a pair of source/drain regions within the base semiconductor layer;
a stepped spacer structure over the base semiconductor layer, wherein the stepped spacer structure extends along a length of the pair of opposing first side surfaces of the insulator layer and over the second top edge of the stepped gate structure; and
additional gate structures extending over a portion of the second top edge of the gate extension region adjacent to the pair of opposing second side surfaces of the insulator layer.

### Embodiment 10:

The semiconductor device of embodiment 8 or the FET device of embodiment 9, wherein a portion of the additional gate structures are over a trench isolation region in the base semiconductor layer.

### Embodiment 11:

The semiconductor device of embodiment 8 or 10 or the FET device of embodiment 9 or 10, wherein the additional gate structures are inactive gate structures.

### Embodiment 12:

The semiconductor device of embodiment 8 or 10 or 11 or the FET device of one of embodiments 9 to 11, further comprising a set of spacers horizontally adjacent the additional gate structures and wherein at least one spacer of the set of spacers is on the second top edge.

### Embodiment 13:

The semiconductor device of embodiment 8 or 10 or 11 or 12 or the FET device of one of embodiments 9 to 12, further comprising a back terminal separated from the stepped gate structure by a trench isolation region in the base semiconductor layer.

### Embodiment 14:

The semiconductor device of embodiment 8 or 10 or 11 or 12 or 13 or the FET device of one of embodiments 9 to 13, wherein the stepped spacer structure includes:
a first spacer layer, including a first material, adjacent to and over the second top edge of the stepped gate structure, the first spacer layer extending along the pair of opposing first side surfaces of the insulator layer and over the base semiconductor layer; and
a second spacer layer, including a second material, over the first spacer layer, wherein the first material and the second material are different.

### Embodiment 15:

The semiconductor device of embodiment 14 or the FET device of embodiment 14, wherein the first material is silicon-based.

### Embodiment 16:

The semiconductor device of embodiment 8 or 10 or 11 or 12 or 13 or 14 or 15 or the FET device of one of embodiments 9 to 15, wherein the gate extension region is over a portion of at least one source/drain region of the pair of source/drain regions.

### Embodiment 17:

A method comprising:
forming a stepped gate structure over an insulator layer over a base semiconductor layer, wherein the stepped gate structure includes:
   a gate body having a first top edge, and
   a gate extension region, adjacent the gate body, having a second top edge, wherein the second top edge is below the first top edge;
forming a pair of source/drain regions within the base semiconductor layer; and
forming a stepped spacer structure over the base semiconductor layer, wherein the stepped spacer structure extends along a side surface of the insulator layer and over the second top edge of the stepped gate structure.

### Embodiment 18:

The method of embodiment 17, wherein forming the stepped spacer structure includes:
forming a first spacer layer, including a first material, adjacent to and over the second top edge of the stepped gate structure, the first spacer layer extending along the side surface of the insulator layer and over the base semiconductor layer; and
forming a second spacer layer, including a second material, over the first spacer layer, wherein the first material and the second material are different.

### Embodiment 19:

The method of embodiment 17 or 18, wherein the gate extension region is over a portion of at least one source/drain region of the pair of source/drain regions.

### Embodiment 20:

The method of one of embodiments 17 to 19, wherein forming the insulator layer includes:
forming the insulator layer with a pair of opposing first side surfaces, and a pair of opposing second side surfaces between the pair of opposing first side surfaces, wherein the stepped spacer structure extends along a length of the pair of opposing first side surfaces but not the pair of opposing second side surfaces.

### Embodiment 21:

The method of embodiment 20, further comprising forming additional gate structures extending over a portion of the second top edge of the gate extension region adjacent to the pair of opposing second side surfaces of the insulator layer.

### Embodiment 22:

The method of one of embodiments 17 to 21, wherein the semiconductor device of one of embodiments 1 to 16 or the FET device of one of embodiments 9 to 16 is formed.

## Claims

1. A semiconductor device comprising:
a stepped gate structure over an insulator layer over a base semiconductor layer, wherein the stepped gate structure includes:
a gate body having a first top edge, and
a gate extension region, adjacent the gate body, having a second top edge,
wherein the second top edge is below the first top edge;
a pair of source/drain regions within the base semiconductor layer; and
a stepped spacer structure over the base semiconductor layer, wherein the stepped spacer structure extends along a side surface of the insulator layer and over the second top edge of the stepped gate structure, the stepped spacer structure preferably extending along a side surface of the insulator layer.

2. The semiconductor device of claim 1, wherein the stepped spacer structure includes:
a first spacer layer, including a first material, adjacent to and over the second top edge of the stepped gate structure, the first spacer layer extending along the side surface of the insulator layer and over the base semiconductor layer; and
a second spacer layer, including a second material, over the first spacer layer, wherein the first material and the second material are different,
wherein the first material preferably is silicon-based.

3. The semiconductor device of claim 1 or 2, wherein the gate extension region is over a portion of at least one source/drain region of the pair of source/drain regions, and/or
wherein the semiconductor device further comprises a trench isolation region in the base semiconductor layer,

4. The semiconductor device of one of claims 1 to 3, wherein the insulator layer includes:
a pair of opposing first side surfaces; and
a pair of opposing second side surfaces between the pair of opposing first side surfaces, wherein the stepped spacer structure extends along a length of the pair of opposing first side surfaces but not the pair of opposing second side surfaces,
wherein the semiconductor device preferably further comprises additional gate structures extending over a portion of the second top edge of the gate extension region adjacent to the pair of opposing second side surfaces of the insulator layer.

5. The semiconductor device of one of claims 1 to 4, wherein the insulator layer comprises:
a pair of opposing first side surfaces, and
a pair of opposing second side surfaces extending between the pair of opposing first side surfaces,
wherein the stepped spacer structure extends along a length of the pair of opposing first side surfaces of the insulator layer and over the second top edge of the stepped gate structure, and
wherein the stepped gate structure further comprises additional gate structures extending over a portion of the second top edge of the gate extension region adjacent to the pair of opposing second side surfaces of the insulator layer.

6. The semiconductor device of claim 5, wherein a portion of the additional gate structures are over a trench isolation region in the base semiconductor layer, and/or
wherein the additional gate structures are inactive gate structures.

7. The semiconductor device of claim 5 or 6, further comprising at least one of:
a set of spacers horizontally adjacent the additional gate structures and wherein at least one spacer of the set of spacers is on the second top edge, and
a back terminal separated from the stepped gate structure by a trench isolation region in the base semiconductor layer.

8. The semiconductor device of one of claims 5 to 7, wherein the stepped spacer structure includes:
a first spacer layer, including a first material, adjacent to and over the second top edge of the stepped gate structure, the first spacer layer extending along the pair of opposing first side surfaces of the insulator layer and over the base semiconductor layer; and
a second spacer layer, including a second material, over the first spacer layer, wherein the first material and the second material are different.

9. The semiconductor device of claim 8, wherein the first material is silicon-based.

10. The semiconductor device of one of claims 5 to 9, wherein the gate extension region is over a portion of at least one source/drain region of the pair of source/drain regions.

11. A method comprising:
forming a stepped gate structure over an insulator layer over a base semiconductor layer, wherein the stepped gate structure includes:
a gate body having a first top edge, and
a gate extension region, adjacent the gate body, having a second top edge,
wherein the second top edge is below the first top edge;
forming a pair of source/drain regions within the base semiconductor layer; and
forming a stepped spacer structure over the base semiconductor layer, wherein the stepped spacer structure extends along a side surface of the insulator layer and over the second top edge of the stepped gate structure.

12. The method of claim 11, wherein forming the stepped spacer structure includes:
forming a first spacer layer, including a first material, adjacent to and over the second top edge of the stepped gate structure, the first spacer layer extending along the side surface of the insulator layer and over the base semiconductor layer; and
forming a second spacer layer, including a second material, over the first spacer layer, wherein the first material and the second material are different.

13. The method of claim 11 or 12, wherein the gate extension region is over a portion of at least one source/drain region of the pair of source/drain regions.

14. The method of one of claims 11 to 13, wherein forming the insulator layer includes:
forming the insulator layer with a pair of opposing first side surfaces, and a pair of opposing second side surfaces between the pair of opposing first side surfaces, wherein the stepped spacer structure extends along a length of the pair of opposing first side surfaces but not the pair of opposing second side surfaces.

15. The method of claim 14, further comprising forming additional gate structures extending over a portion of the second top edge of the gate extension region adjacent to the pair of opposing second side surfaces of the insulator layer.
